# EUROPEAN PATENT APPLICATION

(11) **EP 3 073 527 A1**
(43) Date of publication of application: **28.09.2016**
(21) Application number: 16151985.5
(22) Date of filing: 20.01.2016
(51) Int. Cl.: H01L 25/065, H01L 25/10, H01L 23/488, H01L 23/498, H01L 23/00, H01L 25/00

(54) **SEMICONDUCTOR PACKAGE ASSEMBLY**

(30) Priority: 17.03.2015 US 201562134128 P; 17.06.2015 US 201514741796; 04.11.2015 US 201514932147
(71) Applicant: MediaTek, Inc, Hsin-Chu 300 (TW)
(72) Inventor: LIN, Tzu-Hung, 302 Zhubei City, Hsinchu County (TW); PENG, I-Hsuan, 300 Hsinchu City (TW); HSIAO, Ching-Wen, 300 Hsinchu City (TW)
(74) Representative: Goddar, Heinz J.

(57) **Abstract**

The invention provides a semiconductor package, a semiconductor package assembly and a method for fabricating a semiconductor package. The semiconductor package assembly includes a first semiconductor package. The first semiconductor package includes a first semiconductor die having first pads thereon. A first redistribution layer (RDL) structure is coupled to the first semiconductor die. Conductive pillar structures are disposed on a surface of the first RDL structure away from the first semiconductor die, wherein the conductive pillar structures are coupled to the first RDL structure.

## Description

### CROSS REFERENCE TO RELATED APPLICATIONS

This application is a Continuation-In-Part of pending U.S. patent application Ser. No. 14/741,796, filed on June 17, 2015, entitled "SEMICONDUCTOR PACKAGE ASSEMBLY", which claims the benefit of U.S. Provisional Application No. 62/050,261 filed on September 15, 2014 and U.S. Provisional Application No. 62/058,158 filed on October 1, 2014, and also claims the benefit of U.S. Provisional Application No. 62/134,128 filed on March 17, 2015, the entireties of which are incorporated by reference herein.

### BACKGROUND OF THE INVENTION

### Field of the Invention

The present invention relates to a semiconductor package assembly, and in particular to a hybrid dynamic random access memory (DRAM) package assembly.

### Description of the Related Art

Package-on-package (PoP) package assembly is an integrated circuit packaging method to combine vertically discrete system-on-chip (SOC) and memory packages. Two or more packages are installed atop each other, i.e. stacked, with a standard interface to route signals between them. This allows for higher component density in devices, such as mobile phones, personal digital assistants (PDA), and digital cameras.

For memory applications with increased levels of integration as well as improved performance, bandwidth, latency, power, weight and form factor, the signal pad to ground pad ratio becomes important in improving the coupling effect.

Thus, a novel semiconductor package assembly is desirable.

### BRIEF SUMMARY OF THE INVENTION

A semiconductor package assembly and a method for fabricating a semiconductor package are provided. An exemplary embodiment of a semiconductor package assembly includes a first semiconductor package. The first semiconductor package includes a first semiconductor die having first pads thereon. A first redistribution layer (RDL) structure is coupled to the first semiconductor die. Conductive pillar structures are disposed on a surface of the first RDL structure away from the first semiconductor die, wherein the conductive pillar structures are coupled to the first redistribution layer (RDL) structure.

An exemplary embodiment of a method for fabricating a semiconductor package includes disposing a semiconductor die on a carrier. The semiconductor die has conductive vias on a top surface of the semiconductor die, which is positioned away from the carrier. The conductive vias are coupled to the die pads of the semiconductor die. A molding compound is applied to the carrier to form a molded substrate. A redistribution layer (RDL) structure is formed on the molding compound and coupled to the semiconductor die. Conductive pillar structures are formed on, and coupled to, the RDL structure. The carrier is removed from the back surface of the semiconductor die.

A detailed description is given in the following embodiments with reference to the accompanying drawings.

### BRIEF DESCRIPTION OF THE DRAWINGS

The present invention can be more fully understood by reading the subsequent detailed description and examples with references made to the accompanying drawings, wherein:
FIG. 1 is a cross-sectional view of a semiconductor package assembly including a hybrid system-on-chip (SOC) package and a dynamic random access memory (DRAM) package stacked thereon in accordance with some embodiments of the disclosure;
FIG. 2 is a cross-sectional view of a semiconductor package assembly including a system-on-chip (SOC) package and a hybrid dynamic random access memory (DRAM) package stacked thereon in accordance with some embodiments of the disclosure;
FIGS. 3A-3E are cross-sectional view of a method for fabricating a semiconductor package in accordance with some embodiments of the disclosure;
FIGS. 4A-4E are plan views showing shapes of conductive plugs of conductive pillar structures and redistribution layer (RDL) contact pads of a redistribution layer (RDL) structure in accordance with some embodiments of the disclosure;
FIG. 5 is a cross-sectional view of a semiconductor package assembly including a hybrid system-on-chip (SOC) package and a dynamic random access memory (DRAM) package stacked thereon in accordance with some embodiments of the disclosure; and
FIG. 6 is a cross-sectional view of a semiconductor package assembly including a system-on-chip (SOC) package and a hybrid dynamic random access memory (DRAM) package stacked thereon in accordance with some embodiments of the disclosure.

### DETAILED DESCRIPTION OF THE INVENTION

The following description is of the best-contemplated mode of carrying out the invention. This description is made for the purpose of illustrating the general principles of the invention and should not be taken in a limiting sense. The scope of the invention is determined by reference to the appended claims.

The present invention will be described with respect to particular embodiments and with reference to certain drawings, but the invention is not limited thereto and is only limited by the claims. The drawings described are only schematic and are non-limiting. In the drawings, the size of some of the elements may be exaggerated for illustrative purposes and not drawn to scale. The dimensions and the relative dimensions do not correspond to actual dimensions in the practice of the invention.

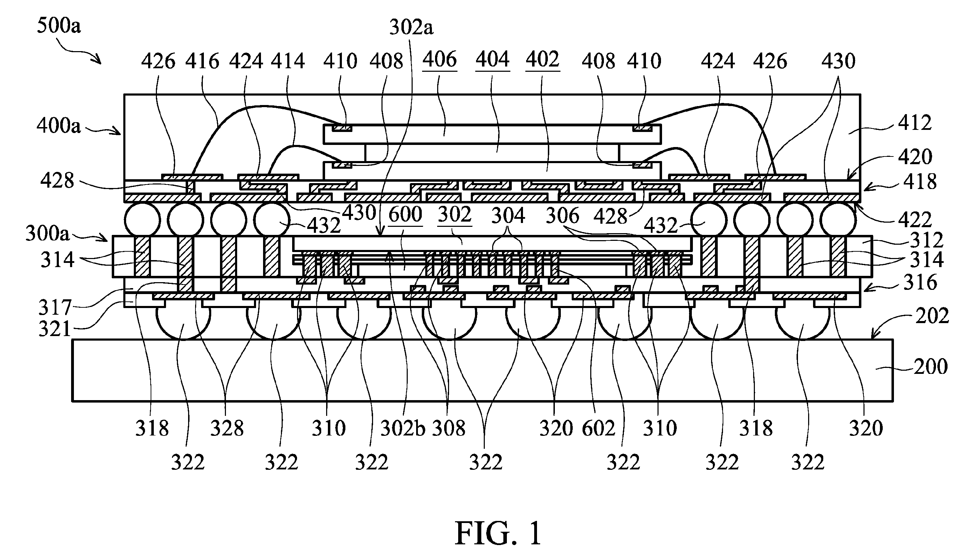

FIG. 1 is a cross-sectional view of a semiconductor package assembly 500a including a hybrid system-on-chip (SOC) package 300a and a dynamic random access memory (DRAM) package 400a stacked thereon in accordance with some embodiments of the disclosure. In some embodiments, the semiconductor package assembly 500a is a package-on-package (POP) semiconductor package assembly. The semiconductor package assembly 500a includes at least two vertically stacked wafer-level semiconductor packages mounted on a base 200. In this embodiment, the vertically stacked wafer-level semiconductor packages include a hybrid system-on-chip (SOC) package 300a and a dynamic random access memory (DRAM) package 400a vertically stacked thereon.

As shown in FIG. 1, the base 200, for example a printed circuit board (PCB), may be formed of polypropylene (PP). It should also be noted that the base 200 can be a single layer or a multilayer structure. A plurality of pads (not shown) and/or conductive traces (not shown) is disposed on a die-attach surface 202 of the base 200. In one embodiment, the conductive traces may comprise signal trace segments or ground trace segments, which are used for the input/output (I/O) connections of the SOC package 300a and the DRAM package 400a. Also, the SOC package 300a is mounted directly on the conductive traces. In some other embodiments, the pads are disposed on the die-attach surface 202, connected to different terminals of the conductive traces. The pads are used for the SOC package 300a mounted directly thereon.

As shown in FIG. 1, the hybrid SOC package 300a is mounted on the die-attach surface 202 of the base 200 by a bonding process. The hybrid SOC package 300a is mounted on the base 200 through the conductive structures 322. The hybrid SOC package 300a is a three-dimensional (3D) semiconductor package including a system on chip (SOC) die 302, a dynamic random access memory (DRAM) die 600 and a redistribution layer (RDL) structure 316. For example, the system on chip (SOC) die 302 may include a logic die including a central processing unit (CPU), a graphic processing unit (GPU), a dynamic random access memory (DRAM) controller or any combination thereof. The dynamic random access memory (DRAM) die 600 may include a Wide I/O DRAM die, vertically stacked on the SOC die 302. In this embodiment, the DRAM die 600 of the hybrid SOC package 300a is fabricated by the through silicon via (TSV) technology. The SOC die 302 and the DRAM die 600 of the hybrid SOC package 300a are connected to each other and/or to the redistribution layer (RDL) structure 316 by vias (such as vias 308, 310). It should be noted that the number of SOC dies 302 and the number of DRAM dies 600 are not limited to the disclosed embodiment.

As shown in FIG. 1, the SOC die 302 has a back surface 302a and a front surface 302b. The SOC die 302 is fabricated by a flip-chip technology. The back surface 302a of the SOC die 302 is close to or aligned with the top surface of the hybrid SOC package 300a. Pads 304 of the SOC die 302 are disposed on the front surface 302b to be electrically connected to the circuitry (not shown) of the SOC die 302. In some embodiments, the pads 304 belong to the uppermost metal layer of the interconnection structure (not shown) of the SOC die 302. The pads 304 of the SOC die 302 are in contact with the corresponding vias 308.

As shown in FIG. 1, the DRAM die 600 is stacked on the front surface 302b of the SOC die 302. The DRAM die 600 is coupled to the pads 304 of the SOC die 302 through the vias 308 disposed on the SOC die 302. The DRAM die 600 may include TSV interconnects 602 formed through the DRAM die 600. The TSV interconnects 602 arranged as an array are used to transmit input/output (I/O), ground or power signals from the DRAM die 600 to the SOC die 302 and/or the base 200. The TSV interconnects 602 may be designed to follow the pin assignment rule (such as JEDEC Wide I/O Memory specification). It should be noted that the number of TSV interconnects in the array is defined by design for the DRAM die 600 and the SOC die 302 mounted thereon and the scope of the disclosure is not limited. The vias 308 are coupled to the TSV interconnects 602.

As shown in FIG. 1, the hybrid SOC package 300a also includes a molding compound 312 surrounding the SOC die 302 and the DRAM die 600, and filling any gaps around the SOC die 302 and the DRAM die 600. The molding compound 312 is in contact with the SOC die 302 and the DRAM die 600. The molded compound 312 also cover the top surface 302b of the SOC die 302. In some embodiments, the molded compound 312 may be formed of a nonconductive material, such as an epoxy, a resin, a moldable polymer, or the like. The molding compound 312 may be applied while substantially liquid, and then may be cured through a chemical reaction, such as in an epoxy or resin. In some other embodiments, the molding compound 312 may be an ultraviolet (UV) or thermally cured polymer applied as a gel or malleable solid capable of being disposed around the SOC die 302 and the DRAM die 600, and then may be cured through a UV or thermal curing process. The molding compound 312 may be cured with a mold.

As shown in FIG. 1, the hybrid SOC package 300a also includes a redistribution layer (RDL) structure 316 is disposed on the DRAM die 600 and the SOC die 302, so that the DRAM die 600 is between the SOC die 302 and the RDL structure 316. The RDL structure 316 may be in contact with the molding compound 312 and the TSV interconnects 602 of the DRAM die 600. In some embodiments, the RDL structure 316 may have one or more conductive traces 318 disposed in one or more intermetal dielectric (IMD) layers 317. The conductive traces 318 are electrically connected to corresponding RDL contact pads 320. The RDL contact pads 320 are exposed to openings of the passivation layer 321. However, it should be noted that the number of conductive traces 318, the number of IMD layers 317 and the number of RDL contact pads 320 shown in FIG. 1 is only an example and is not a limitation to the present invention.

As shown in FIG. 1, the hybrid SOC package 300a also includes conductive structures 322 disposed on a surface of the RDL structure 316 away from the DRAM die 600 and the SOC die 302. The conductive structures 322 are coupled to the conductive traces 318 through the RDL contact pads 320. In some embodiments, the conductive structures 322 may comprise a conductive bump structure such as a copper bump or a solder bump structure, a conductive pillar structure, a conductive wire structure, or a conductive paste structure.

As shown in FIG. 1, the DRAM die 600 uses the TSV interconnects 602 respectively connecting the pads 304 of the SOC die 302 to the conductive traces 318 of the RDL structure 316 by the vias 308. Also, pads 306 of the SOC die 302 are coupled to the conductive traces 318 of the RDL structure 316 by vias 310 passing through the molding compound 312 between the SOC die 302 and the RDL structure 316. The DRAM die 600 is surrounded by the vias 310.

As shown in FIG. 1, the conductive traces 318 may be designed to fan out from one or more of the pads 304 and 306 of the SOC die 302 and TSV interconnects 602 of DRAM die 600 to provide electrical connections between the SOC die 302, DRAM die 600 and the RDL contact pads 320. Therefore, the RDL contact pads 320 may have a larger bond pitch than the pads 304 and 306 of the SOC die 302 and TSV interconnects 602 of DRAM die 600, and which may be suitable for a ball grid array or another package mounting system.

As shown in FIG. 1, the DRAM package 400a is stacked on the hybrid SOC package 300a by a bonding process. In one embodiment, the DRAM package 400a is a low-power double data rate DRAM (LPDDR DRAM) package following the pin assignment rule (such as JEDEC LPDDR I/O Memory specification). The DRAM package 400a includes a body 418 and at least one LPDDR DRAM die, for example, three LPDDR DRAM dies 402, 404 and 406, stacked thereon. The body 418 has a die-attach surface 420 and a bump-attach surface 422 opposite the die-attach surface 420. In some embodiments, the number of input/output (I/O) pins of Wide I/O DRAM die 600 is designed to be different from the number of input/output (I/O) pins of each of the LPDDR DRAM dies 402, 404 and 406. In one embodiment, the number of input/output (I/O) pins of Wide I/O DRAM die 600 is eight times greater than the number of input/output (I/O) pins of each of the LPDDR DRAM dies 402, 404 and 406. In this embodiment, as shown in FIG. 1, there are three LPDDR DRAM dies 402, 404 and 406 mounted on the die-attach surface 420 of the body 418. The LPDDR DRAM die 404 is stacked on the LPDDR DRAM die 402 with a paste (not shown), and the LPDDR DRAM die 406 is stacked on the LPDDR DRAM die 404 with a paste (not shown). The LPDDR DRAM dies 402, 404 and 406 may be coupled to the body 418 by bonding wires, for example bonding wires 414 and 416. However, the number of stacked DRAM devices is not limited to the disclosed embodiment. Alternatively, the three LPDDR DRAM dies 402, 404 and 406 as shown in FIG. 1 can be arranged side by side. Therefore, the LPDDR DRAM dies 402, 404 and 406 are mounted on the die-attach surface 420 of the body 418 using paste. The body 418 may comprise circuitry 428 and metal pads 424 and 426 and 430. The metal pads 424 and 426 are disposed on the top of the circuitry 428 close to the die-attach surface 420. The metal pads 430 are disposed on the bottom of the circuitry 428 close to the bump-attach surface 430. The circuitry 428 of the DRAM package 400a is interconnected with the conductive traces 318 of the RDL structure 316 via a plurality of conductive structures 432 disposed on the bump-attach surface 422 of the body 418. In some embodiments, the conductive structures 432 may comprise a conductive bump structure such as a copper bump or a solder bump structure, a conductive pillar structure, a conductive wire structure, or a conductive paste structure. In some embodiments, the DRAM package 400a is coupled to the conductive traces 318 of the RDL structure 316 by the vias 314 passing through the molding compound 312 between the DRAM package 400a and the RDL structure 316 of the hybrid SOC package 300a. The SOC die 302 and the DRAM die 600 are surrounded by the vias 314.

In one embodiment, as shown in FIG. 1, the DRAM package 400a also includes a molding material 412 covering the die-attach surface 420 of the body 418, encapsulating the LPDDR DRAM dies 402, 404 and 406, the bonding wires 414 and 416.

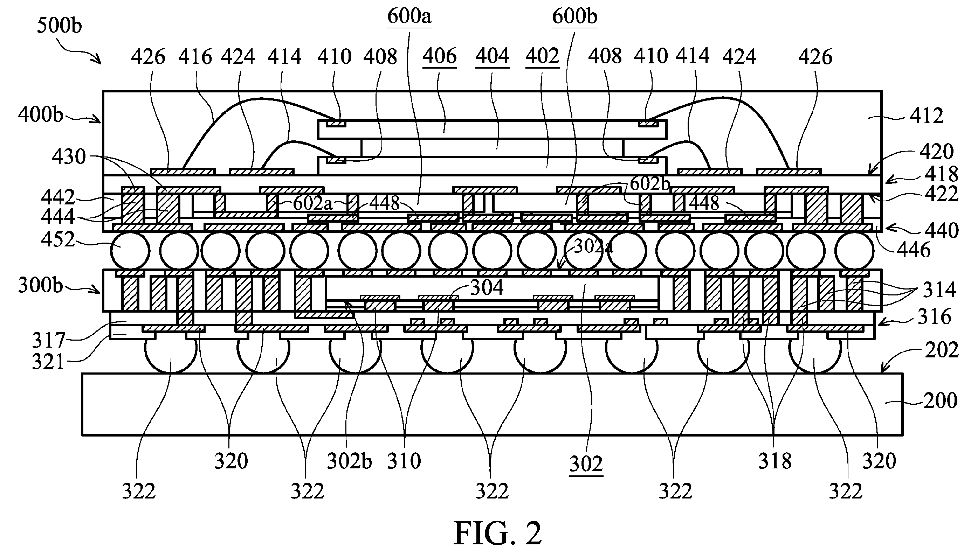

FIG. 2 is a cross-sectional view of a semiconductor package assembly 500b including a system-on-chip (SOC) package 300b and a hybrid dynamic random access memory (DRAM) package 400b stacked thereon in accordance with some embodiments of the disclosure. Elements of the embodiments hereinafter, that are the same as, or similar to, those previously described with reference to FIG. 1, are not repeated for brevity. The differences between the semiconductor package assembly 500a and the semiconductor package assembly 500b is that the semiconductor package assembly 500b includes a pure system-on-chip (SOC) package 300b and a hybrid DRAM package 400b vertically stacked thereon.

As shown in FIG. 2, the SOC package 300b is a semiconductor package including a system on chip (SOC) die 302 and a redistribution layer (RDL) structure 316. The SOC package 300b does not include any DRAM die integrated therein. The SOC die 302 of the SOC package 300b is connected to the redistribution layer (RDL) structure 316 by vias (such as vias 310). The pads 304 of the SOC die 302 are in contact with the corresponding vias 308. It should be noted that the number of SOC dies 302 is not limited to the disclosed embodiment.

As shown in FIG. 2, the hybrid DRAM package 400b is stacked on the SOC package 300b by the bonding process. The hybrid DRAM package 400b is a three-dimensional (3D) semiconductor package including a wire bonding DRAM package stacked on a TSV DRAM package. In this embodiment, the hybrid DRAM package 400b is a LPDDR DRAM/Wide I/O DRAM hybrid package including LPDDR DRAM dies following a specific pin assignment rule (such as JEDEC LPDDR I/O Memory specification) and Wide I/O DRAM dies following another specific pin assignment rule (such as JEDEC Wide I/O Memory specification). The hybrid DRAM package 400b includes a body 418, at least one LPDDR DRAM die and at least one Wide I/O DRAM die stacked on the body 418. In some embodiments as shown in FIG. 2, there are three LPDDR DRAM dies 402, 404 and 406 mounted on the die-attach surface 420 of the body 418. The LPDDR DRAM die 404 is stacked on the LPDDR DRAM die 402 with a paste (not shown), and the LPDDR DRAM die 406 is stacked on the LPDDR DRAM die 404 with a paste (not shown). The LPDDR DRAM dies 402, 404 and 406 may be coupled to the body 418 by bonding wires, for example bonding wires 414 and 416. However, the number of stacked LPDDR DRAM dies is not limited to the disclosed embodiment. Alternatively, the three LPDDR DRAM dies 402, 404 and 406 as shown in FIG. 1 can be arranged side by side. Therefore, the LPDDR DRAM dies 402, 404 and 406 are mounted on the die-attach surface 420 of the body 418 using paste.

In one embodiment, as shown in FIG. 2, the body 418 may comprise circuitry (not shown) and metal pads 424 and 426 and 430. The metal pads 424 and 426 are disposed on the top of the circuitry 428 close to the die-attach surface 420. The metal pads 430 are disposed on the bottom of the circuitry 428 close to the bump-attach surface 430.

In one embodiment, as shown in FIG. 2, the hybrid DRAM package 400b also includes a molding material 412 covering the die-attach surface 420 of the body 418, encapsulating the LPDDR DRAM dies 402, 404 and 406, the bonding wires 414 and 416.

As shown in FIG. 2, the hybrid DRAM package 400b also includes at least one Wide I/O DRAM die, for example, two Wide I/O DRAM dies 600a and 600b, embedded therein. In this embodiment, there are two Wide I/O DRAM dies 600a and 600b mounted on the bump-attach surface 422, coupled to the metal pads 430 of the body 418. The Wide I/O DRAM dies 600a and 600b are arranged side by side. However, the number and the arrangement of stacked Wide I/O DRAM dies are not limited to the disclosed embodiment. The Wide I/O DRAM dies 600a and 600b may include corresponding TSV interconnects 602a and 602b formed through the Wide I/O DRAM dies 600a and 600b, respectively. The TSV interconnects 602a and 602b arranged as an array are used to transmit input/output (I/O), ground or power signals from the Wide I/O DRAM dies 600a and 600b to the LPDDR DRAM dies 402, 404 and 406 and/or the base 200. The TSV interconnects 602a and 602b may be designed to follow the pin assignment rule (such as JEDEC Wide I/O Memory specification). It should be noted that the number of TSV interconnects in the array is defined by design for the Wide I/O DRAM dies 600a and 600b and the LPDDR DRAM dies 402, 404 and 406 mounted thereon and the scope of the disclosure is not limited. The TSV interconnects 602 are coupled to the metal pads 430 of the body 418. In some embodiments, the number of input/output (I/O) pins of Wide I/O DRAM dies 600a and 600b are designed to be different from the number of input/output (I/O) pins of each of the LPDDR DRAM dies 402, 404 and 406. In one embodiment, the number of input/output (I/O) pins of Wide I/O DRAM dies 600a and 600b is eight times greater than the number of input/output (I/O) pins of each of the LPDDR DRAM dies 402, 404 and 406.

As shown in FIG. 2, the hybrid DRAM package 400b also includes a molding compound 442 disposed on the bump-attach surface 422 of the body 418. The molding compound 442 surrounds the Wide I/O DRAM dies 600a and 600b, and filling any gaps around the Wide I/O DRAM dies 600a and 600b. The molding compound 442 is in contact with the Wide I/O DRAM dies 600a and 600b.

As shown in FIG. 2, the hybrid DRAM package 400b also includes a redistribution layer (RDL) structure 440 on the bump-attach surface 422 of the body 418. The RDL structure 440 is also disposed on the LPDDR DRAM dies 402, 404 and 406 and the Wide I/O DRAM dies 600a and 600b. The Wide I/O DRAM dies 600a and 600b is between the body 418 and the RDL structure 440. The RDL structure 440 may be in contact with the molding compound 442 and the TSV interconnects 602a and 602b of the DRAM dies 600a and 600b. The RDL structure 440 may have one or more conductive traces 448 disposed in one or more intermetal dielectric (IMD) layers 446. The conductive traces 448 are electrically connected to corresponding RDL contact pads 450. However, it should be noted that the number of conductive traces 448, the number of IMD layers 446 and the number of RDL contact pads 450 shown in FIG. 1 is only an example and is not a limitation to the present invention.

As shown in FIG. 2, the LPDDR DRAM dies 402, 404 and 406 may be coupled to the RDL contact pads 450 of the RDL structure 440 by vias 444 passing through the molding compound 442 between the molding compound 442 and the RDL structure 440. The Wide I/O DRAM dies 600a and 600b are surrounded by the vias 444.

As shown in FIG. 2, the conductive traces 448 of the DRAM package 400b is interconnected with the conductive traces 318 of the RDL structure 316 of the SOC package 300b via a plurality of conductive structures 452 disposed on the RDL contact pads 450 of the RDL structure 440. In some embodiments, the conductive structures 452 may comprise a conductive bump structure such as a copper bump or a solder bump structure, a conductive pillar structure, a conductive wire structure, or a conductive paste structure. In some embodiments, the conductive structures 452 of the DRAM package 400b are coupled to the RDL structure 316 of the SOC package 300b by the vias 314 passing through the molding compound 312 between the DRAM package 400b and the RDL structure 316 of the SOC package 300b. The SOC die 302 is surrounded by the vias 314.

Embodiments provide semiconductor package assemblies 500b and 500b. Each of the semiconductor package assemblies 500b and 500b provides a LPDDR DRAM and Wide I/O DRAM hybrid memory integrated with a POP semiconductor package assembly. The POP semiconductor package assembly 500a includes a SOC/Wide I/O DRAM hybrid package 300a and a LPDDR DRAM package 400a stacked thereon. The POP semiconductor package assembly 500b includes a pure SOC package 300b and a LPDDR/Wide I/O DRAM hybrid package 400b stacked thereon. The semiconductor package assemblies 500a and 500b have advantages of the LPDDR DRAM package assembly (such as cost-effective, quick transition, and etc.) and the Wide I/O DRAM package assembly (such as high bandwidth, low power, etc.). The semiconductor package assemblies 500a and 500b may satisfy the requirements of cost-efficiency, high bandwidth, low power and quick transition.

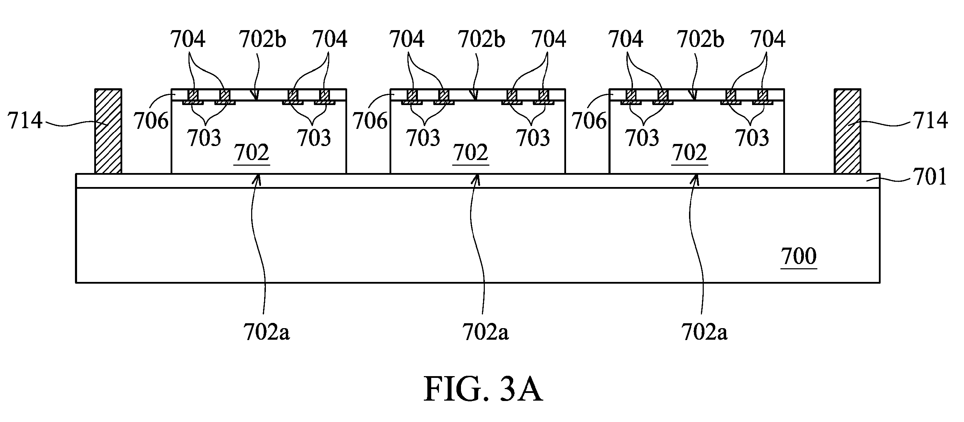

In some embodiments, the conductive structures coupled to the pure system-on-chip (SOC) package and the hybrid system-on-chip (SOC) package as shown in FIGS. 1 and 2 are conductive pillar structures. In some embodiments, the conductive pillar structures are composed of a metal stack comprising a UBM (under bump metallurgy) layer (not shown), a conductive plug and a corresponding solder cap. FIGS. 3A-3E are cross-sectional view of a method for fabricating a semiconductor package (e.g. semiconductor packages 350a-350c) in accordance with some embodiments of the disclosure.

As shown in FIG. 3A, a carrier 700 is provided. The carrier 700 may be configured to provide structural rigidity or a base for deposition of subsequent non-rigid layers. Next, a plurality of semiconductor dies 702 separated from each other is disposed attached to a carrier 700 through a dielectric layer 701. Backside surfaces 702a of the semiconductor dies 702 are in contact with the dielectric layer 701. Top surfaces 702b of the semiconductor dies 702 may face away from the carrier 700. In some embodiments, the semiconductor dies 702 are system-on-chip (SOC) dies, which are the same as, or similar to, the SOC die 302 shown in FIGS. 1 and 2.

In some embodiment as shown in FIG. 3A, each of the semiconductor dies 702 has die pads 703 and corresponding conductive vias 704. The die pads 703 are formed close to the top surface 702b. A dielectric layer 706 is formed covering the top surface 702b of the semiconductor die 702 and portions of the die pads 703. The conductive vias 704, which are positioned corresponding to the die pads 703 is disposed on the top surface 702b of the semiconductor die 702. The conductive vias 704 pass through the dielectric layer 706. The conductive vias 704 are in contact with and coupled to the die pads 703 of the semiconductor die 702. In some other embodiments, at least one via structure 714 is disposed on the carrier 700. Also, the via structure 714 is disposed beside the semiconductor die 702.

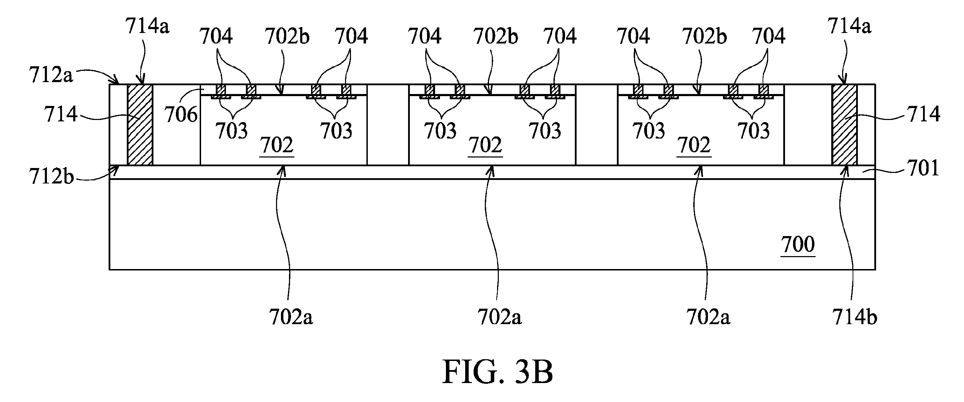

Next, as shown in FIG. 3B, a molding compound 712 may be applied to the carrier 700. The molding compound 712 may surround the semiconductor dies 702, and fill any gaps around the semiconductor dies 702. The molding compound 712 also cover the top surfaces 702b of the semiconductor dies 702 and the conductive vias 704, In some other embodiments, the molding compound 712 surrounds the via structure 714, leaving the top surface 714a of the via structure 714 exposed from the top surface 712a of the molding compound 712. In some embodiments, the materials and the fabrication processes of the molding compound 312 shown in FIGS. 1 and 2 are the same as, or similar to, those of the molding compound 712.

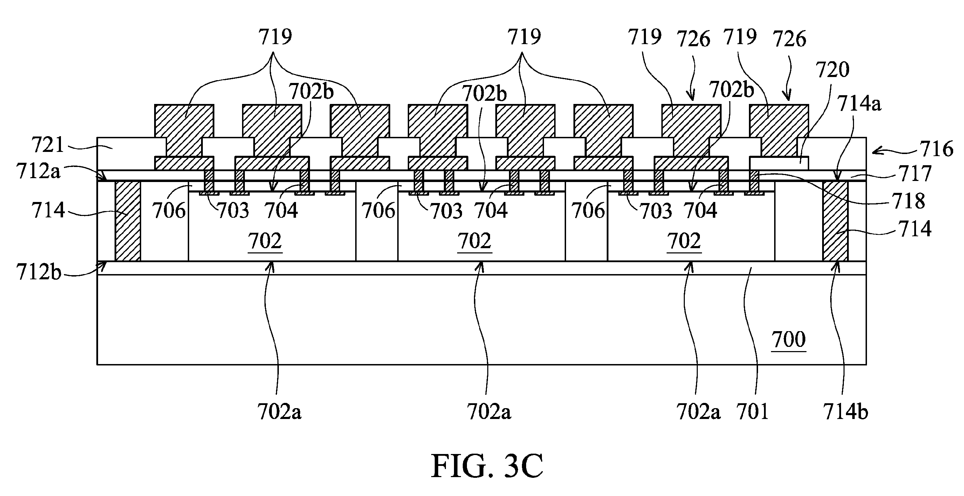

Next, as shown in FIG. 3C, a redistribution layer (RDL) structure 716 is formed on the molding compound and coupled to the semiconductor dies 702 by a deposition process, a photolithography process, an anisotropic etching process and an electroplating process. In some embodiments, the RDL structure 716 may have one or more conductive traces 718 disposed in one or more intermetal dielectric (IMD) layers 717. Also, the RDL structure 716 may have one or more RDL contact pads 720 and a passivation layer 721. The RDL contact pads 720 are in contact with the corresponding conductive traces 718 and covered by the passivation layer 721. In some embodiments, the materials and the fabrication processes of the RDL structure 316 shown in FIGS. 1 and 2 are the same as, or similar to, those of the RDL structure 716.

In some embodiments, as shown in FIG. 3C, before forming the RDL structure 716, a photolithography process may be used to form a plurality of openings (not shown) that pass through a portion of the molding compound 712 from the surface of the molding compound 712 close to the top surfaces 702b of the first semiconductor dies 702. Therefore, the conductive traces 718 are also formed filling the opening of the molding compound 712 to be coupled to the conductive vias 704. Also, the conductive traces 718 are electrically connected to corresponding RDL contact pads 720. The RDL contact pads 720 are exposed to openings (not shown) of the passivation layer 721.

Next, as shown in FIG. 3C-3D, conductive pillar structures 726 are formed on, and coupled to, the RDL structure 716. As shown in FIG. 3C, a photolithography process is performed to form a photoresist pattern (not shown) covering the passivation layer 721. Next, an anisotropic etching process is performed to form openings (not shown) passing through the passivation layer 721 of the RDL structure 716. In some embodiments, the openings (not shown) are positioned to correspond with the RDL contact pads 720 of the RDL structure 716.

Afterwards, the photoresist pattern is removed from the passivation layer 721. Next, an electroplating process is performed to form conductive plugs 719 filling the openings (not shown) and connecting the RDL contact pads 720. The conductive plugs 719 protruding beyond the redistribution layer (RDL) structure 716 are formed. As shown in FIG. 3C, the conductive plug 719 has a lower portion embedded in the passivation layer 721 and an upper portion protruding beyond the passivation layer 721. The upper portion of the conductive plug 719 is wider than the lower portion of the conductive plug 719. In some embodiments, the width of the upper portion of the conductive plug 719 is in a range from about 2 µm to about 5 µm. In some embodiments, the upper and lower portions of the conductive plug 719 have the same or similar shape.

In some other embodiments, the photoresist pattern is removed from the passivation layer 721 after the formation of the conductive plugs 719. As a result, the width of the upper portion of the conductive plug 719 is substantially the same as that of the lower portion of the conductive plug 719.

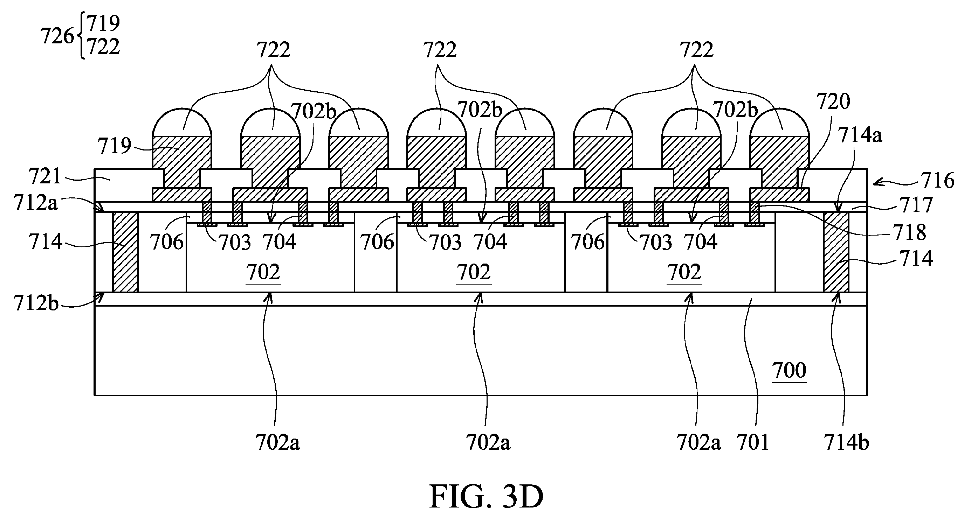

Next, as shown in FIG. 3D, solder caps 722 are respectively formed on the corresponding conductive plugs 719 by a photolithography process, a solder plating process, a photoresist stripping process and a solder reflow process. Next, the carrier 700 and the dielectric layer 701 (shown in FIG. 3C) is removed from the back surface 702a of the semiconductor dies 702. In some embodiments, the conductive plug 719 and the corresponding solder cap 722 collectively form a conductive pillar structure 726.

In some other embodiments, the back surface 702a of the semiconductor dies 702 and the bottom surface 714b of the via structure 714 are exposed from the bottom surface 712b of the molding compound 712.

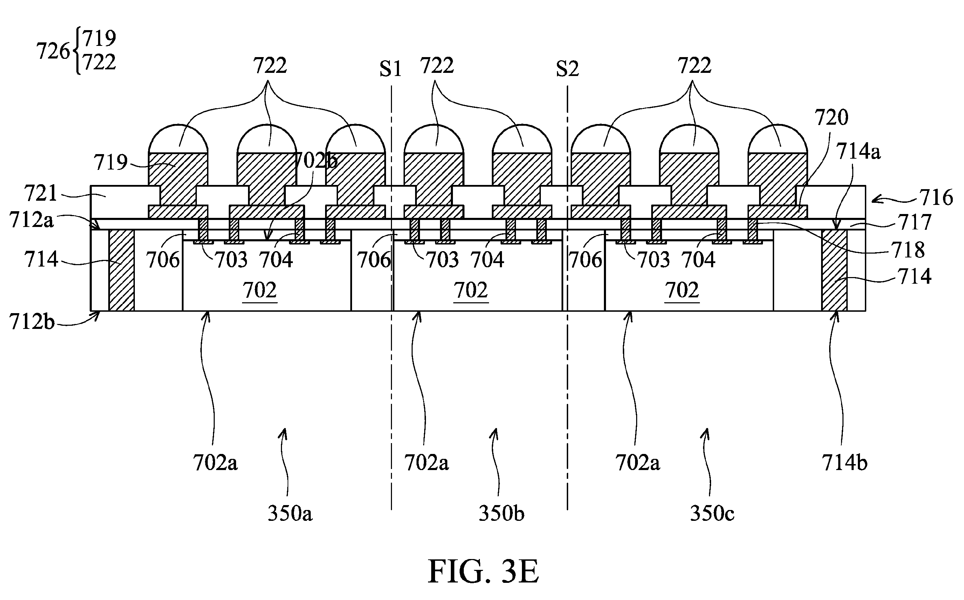

Next, as shown in FIG. 3E, a separation process is performed to cut the RDL structure 716 and the molding compound 712 along scribe lines S1 and S2, which are positioned between the semiconductor dies 702. After performing the separation process, individual semiconductor packages 305a, 350b and 350c are formed. For example, each of the semiconductor packages 305a and 350c include the via structure 714 passing through molding compound 712. In some embodiments, the materials and the fabrication processes of the vias 314 shown in FIGS. 1 and 2 are the same as, or similar to, those of the via structure 714. The semiconductor package 350b is fabricated without any via structure. It should be noted that the number of semiconductor packages is not limited to the disclosed embodiment.

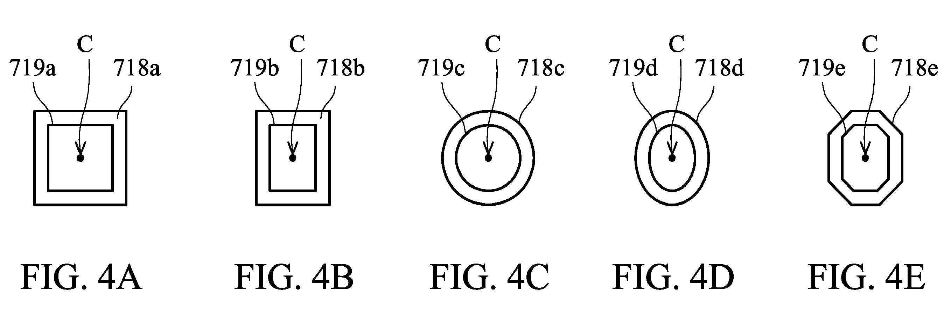

FIGS. 4A-4E are plan views showing shapes of the conductive plugs of the conductive pillar structures and redistribution layer (RDL) contact pads of the redistribution layer (RDL) structure in accordance with some embodiments of the disclosure. In some embodiments, the conductive plugs 719a-719e may be designed to have a shape that is similar to the corresponding RDL contact pads 718a-718e of the RDL structure (e.g. the RDL structure 716 shown in FIG. 3E) in the plan views shown FIGS. 4A-4E. In some embodiments, the conductive plugs 719a-719e of the conductive pillar structure may be designed to have 2-fold rotational symmetry, which is a 180 degrees rotation around a middle point C of the conductive plugs 719a-719e, in the plan views shown FIGS. 4A-4E. In some embodiments, the conductive plug 719a and the corresponding RDL contact pad 718a are square shapes in the plan view shown in FIG. 4A. The conductive plug 719b and the corresponding RDL contact pad 718b are rectangular shapes in the plan view shown in FIG. 4B. The conductive plug 719c and the corresponding RDL contact pad 718c are circular shapes in the plan view shown in FIG. 4C. The conductive plug 719d and the corresponding RDL contact pad 718d are oval shapes in the plan view shown in FIG. 4D. The conductive plug 719e and the corresponding RDL contact pad 718e are octagonal shapes in the plan view shown in FIG. 4E.

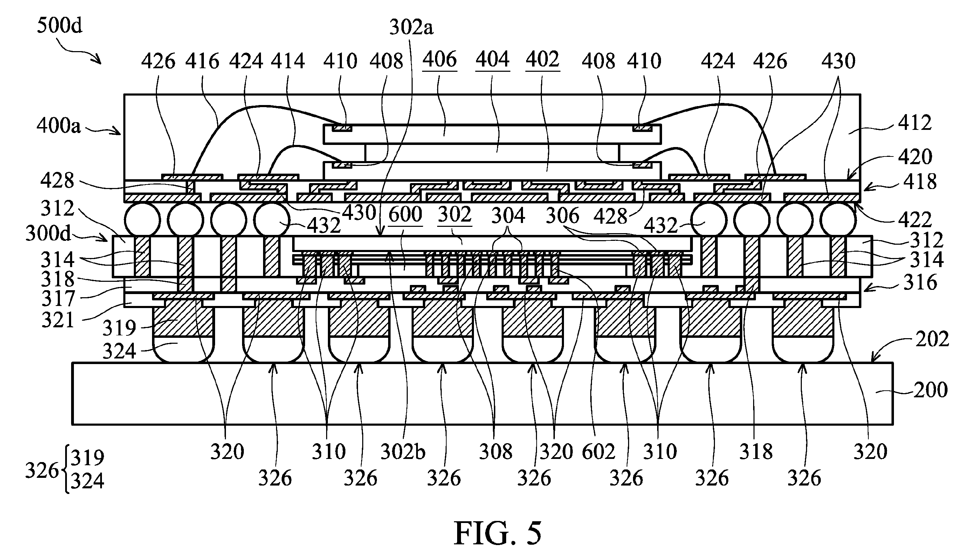

FIG. 5 is a cross-sectional view of a semiconductor package assembly 500d including a hybrid system-on-chip (SOC) package 300d and a dynamic random access memory (DRAM) package 400a stacked thereon in accordance with some embodiments of the disclosure. Descriptions of elements of the embodiments hereinafter that are the same as, or similar to, those previously described with reference to FIGS. 1-2 are omitted for brevity.

As shown in FIG. 5, one of the differences between the semiconductor package assembly 500a shown in FIG. 1 and the semiconductor package assembly 500d is that the semiconductor package assembly 500d includes conductive pillar structures 326 disposed on a surface of the first RDL structure 316 away from the first semiconductor die 302. The conductive pillar structures 326 are coupled to the corresponding RDL contact pads 320 of the first RDL structure 316 of the hybrid SOC package 300d. In some embodiments, each of the conductive pillar structures 326 are composed of a metal stack comprising a conductive plug 319 and the corresponding solder cap 324. In some embodiments, the materials and the fabrication processes of the molding compound 312, the vias 314 and the first RDL structure 316 shown in FIG. 5 are the same as, or similar to, those of the molding compound 712, the via structures 714 and the RDL structure 716 shown in FIGS. 3A-3C. In some embodiments, the materials and the fabrication processes of the conductive plug 319 and the solder cap 324 shown in FIG. 5 are the same as, or similar to, those of the conductive plug 719 and the solder cap 722 shown in FIGS. 3C-3E. Also, shapes of the conductive plug 319 and the corresponding RDL contact pads 320 in the plan view may be the same as, or similar to, those of the conductive plugs 719a-719e and the corresponding RDL contact pads 718a-718e in the plan views shown FIGS. 4A-4E.

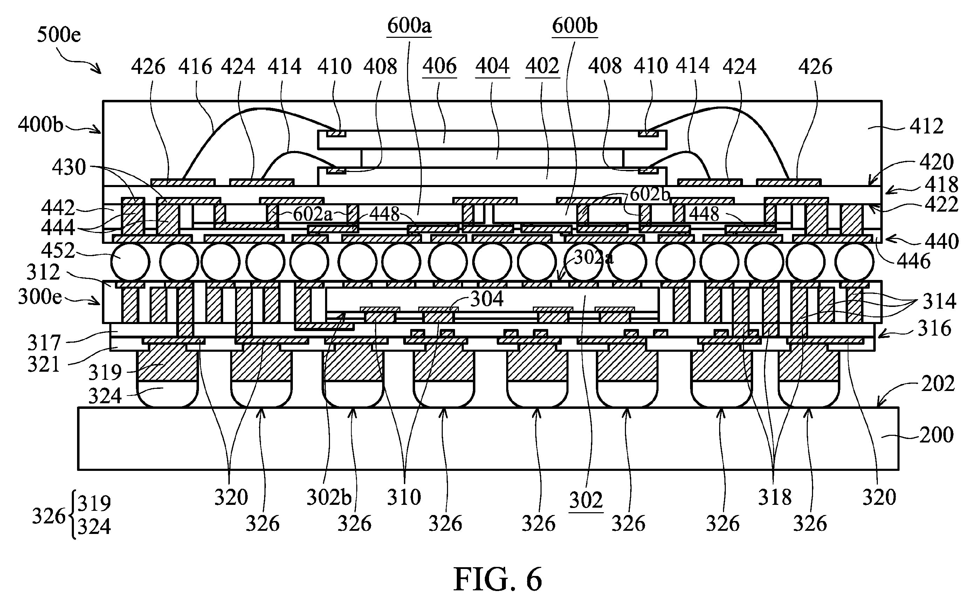

FIG. 6 is a cross-sectional view of a semiconductor package assembly 500e including a system-on-chip (SOC) package 300e and a hybrid dynamic random access memory (DRAM) package 400b stacked thereon in accordance with some embodiments of the disclosure. Descriptions of elements of the embodiments hereinafter that are the same as, or similar to, those previously described with reference to FIGS. 1-2 and 5 are omitted for brevity.

As shown in FIG. 6, one of the differences between the semiconductor package assembly 500b shown in FIG. 2 and the semiconductor package assembly 500e is that the semiconductor package assembly 500e includes conductive pillar structures 326 disposed on a surface of the first RDL structure 316 away from the first semiconductor die 302. The conductive pillar structures 326 are coupled to the corresponding RDL contact pads 320 of the first RDL structure 316 of the hybrid SOC package 300e. In some embodiments, the conductive pillar structures 326 of the semiconductor package assembly 500e are the same as, or similar to, those of the conductive pillar structures 326 of the semiconductor package assembly 500d shown in FIG. 5. In some embodiments, the materials and the fabrication processes of the conductive plug 319 and the solder cap 324 shown in FIG. 6 are the same as, or similar to, those of the conductive plug 719 and the solder cap 722 shown in FIGS. 3C-3E. Also, shapes of the conductive plug 319 and the corresponding RDL contact pads 320 in the plan view may be the same as, or similar to, those of the conductive plugs 719a-719e and the corresponding RDL contact pads 718a-718e in the plan views shown FIGS. 4A-4E.

In some embodiments, the conductive pillar structure disposed on the pure system-on-chip (SOC) package or the hybrid system-on-chip (SOC) package of the semiconductor package assembly may have the following advantages. The conductive pillar structure is composed of a metal stack comprising a conductive plug and a corresponding solder cap. The conductive plug of the conductive pillar structure is formed protruding beyond the redistribution layer (RDL) structure, so that the ball bridge problem and the package warpage problem is avoided. The capability of the base (the printed circuit board) is improved. Also, the conductive pillar structure can facilitate the surface-mount technology (SMT) rework process for the solder cap of the wafer-level semiconductor package. Therefore, the reliability of the SOC package and the semiconductor package assembly is improved.

The invention relates to a semiconductor package assembly comprising a first semiconductor package, comprising a first semiconductor die having first pads thereon; and a first redistribution layer (RDL) structure coupled to the first semiconductor die; and conductive pillar structures disposed on a surface of the first RDL structure away from the first semiconductor die, wherein the conductive pillar structures are coupled to the first redistribution layer (RDL) structure.

In an embodiment the conductive pillar bump is composed of a metal stack comprising a conductive plug and a solder cap in contact with the conductive plug.

In an embodiment the conductive plug is a square shape, a rectangular shape, a circular shape, an octagonal shape or oval shape in a plan view.

In an embodiment the conductive plug has a similar shape to a corresponding RDL contact pad of the first RDL structure in a plan view.

In an embodiment the conductive plug has 2-fold rotational symmetry, which is a 180 degrees rotation around a middle point of the conductive plug, in a plan view.

In an embodiment the semiconductor package assembly further comprises a second semiconductor package stacked on the first semiconductor package, comprising a body having a die-attach surface and a bump-attach surface opposite the die-attach surface; and a second dynamic random access memory (DRAM) die mounted on the die-attach surface, coupled to the body through the bonding wires, wherein a number of input/output (I/O) pins of first DRAM die is different from a number of input/output (I/O) pins of the second DRAM die.

In an embodiment one of the first semiconductor and the second semiconductor package further comprises an additional dynamic random access memory (DRAM) die embedded therein, wherein the additional DRAM die has through silicon via (TSV) interconnects formed through the additional DRAM die.

In an embodiment the number of input/output (I/O) pins of first DRAM die is eight times greater than the number of input/output (I/O) pins of the second DRAM die.

In an embodiment the first semiconductor package comprises first vias disposed on the first semiconductor die, coupled to the first pads.

In an embodiment the additional DRAM die is embedded in the SOC package, coupled to first vias on the first semiconductor die and the first RDL structure.

In an embodiment the first DRAM die is disposed between the first semiconductor die and the RDL structure.

In an embodiment the first semiconductor package comprises a molding compound surrounding the first semiconductor die and the first DRAM die, being in contact with the RDL structure, the first semiconductor die and the first DRAM die.

In an embodiment the second semiconductor package is coupled to the first conductive traces by second vias passing through the molding compound between the second semiconductor package and the RDL structure.

In an embodiment the first semiconductor die is surrounded by the second vias.

In an embodiment the first semiconductor die is coupled to the first conductive traces by third vias passing through the molding compound between the first semiconductor die and the RDL structure.

In an embodiment the first DRAM die is surrounded by the third vias.

In an embodiment the DRAM package comprises a second redistribution layer (RDL) structure disposed on the bump-attach surface.

In an embodiment the additional DRAM die is disposed between the body and the second RDL structure.

In an embodiment the semiconductor package assembly further comprises a base, wherein the first and second semiconductor packages are mounted on the base through the first conductive structures.

The invention further relates to a method for fabricating a semiconductor package, comprising disposing a semiconductor die on a carrier, wherein the semiconductor die has conductive vias on a top surface of the semiconductor die, which is positioned away from the carrier, wherein the conductive vias are coupled to the die pads of the semiconductor die; applying a molding compound to the carrier to form a molded substrate; forming a redistribution layer (RDL) structure on the molding compound and coupled to the semiconductor die; forming a conductive pillar structures on and coupled to of the RDL structure; removing the carrier from a back surface of the semiconductor die.

In an embodiment forming the conductive pillar structures comprises forming openings passing through a passivation layer of the redistribution layer (RDL) structure, wherein the openings are positioned corresponding redistribution layer (RDL) contact pads of the redistribution layer (RDL) structure; forming conductive plugs filling the openings and connecting the redistribution layer (RDL) contact pads, wherein the conductive plugs protrude beyond the redistribution layer (RDL) structure; and forming solder caps on the respective conductive plugs.

In an embodiment the method for fabricating further comprises disposing a via structure on the carrier and beside the semiconductor die before applying a molding compound to the carrier.

The invention further relates to a semiconductor package comprising a first semiconductor die having first pads thereon; a first redistribution layer (RDL) structure coupled to the first semiconductor die; and conductive pillar structures disposed on a surface of the first RDL structure away from the first semiconductor die, wherein the conductive pillar structures are coupled to the first RDL structure.

In an embodiment the conductive pillar structures are composed of a metal stack comprising a conductive plug and a solder cap in contact with the conductive plug.

In an embodiment the conductive plug is a square shape, a rectangular shape, a circular shape, an octagonal shape or an oval shape in a plan view.

In an embodiment the conductive plug has a similar shape to a corresponding RDL contact pad of the first RDL structure in a plan view.

In an embodiment the conductive plug has 2-fold rotational symmetry, which is a 180 degrees rotation around a middle point of the conductive plug, in a plan view.

While the invention has been described by way of example and in terms of the preferred embodiments, it is to be understood that the invention is not limited to the disclosed embodiments. On the contrary, it is intended to cover various modifications and similar arrangements (as would be apparent to those skilled in the art). Therefore, the scope of the appended claims should be accorded the broadest interpretation so as to encompass all such modifications and similar arrangements.

## Claims

1. A semiconductor package assembly, comprising:
a first semiconductor package, comprising:
a first semiconductor die having first pads thereon; and
a first redistribution layer (RDL) structure coupled to the first semiconductor die; and
conductive pillar structures disposed on a surface of the first RDL structure away from the first semiconductor die, wherein the conductive pillar structures are coupled to the first redistribution layer (RDL) structure.

2. The semiconductor package assembly as claimed in claim 1, wherein the conductive pillar bump is composed of a metal stack comprising a conductive plug and a solder cap in contact with the conductive plug.

3. The semiconductor package assembly as claimed in claim 2, wherein the conductive plug is a square shape, a rectangular shape, a circular shape, an octagonal shape or oval shape in a plan view.

4. The semiconductor package assembly as claimed in claim 2, wherein the conductive plug has a similar shape to a corresponding RDL contact pad of the first RDL structure in a plan view.

5. The semiconductor package assembly as claimed in claim 2, wherein the conductive plug has 2-fold rotational symmetry, which is a 180 degrees rotation around a middle point of the conductive plug, in a plan view.

6. The semiconductor package assembly as claimed in any of the preceding claims, further comprising:
a second semiconductor package stacked on the first semiconductor package, comprising:
a body having a die-attach surface and a bump-attach surface opposite the die-attach surface; and
a second dynamic random access memory (DRAM) die mounted on the die-attach surface, coupled to the body through bonding wires,
wherein a number of input/output (I/O) pins of the first semiconductor die is different from a number of input/output (I/O) pins of the second DRAM die.

7. The semiconductor package assembly as claimed in claim 6, wherein one of the first semiconductor package and the second semiconductor package further comprises an additional dynamic random access memory (DRAM) die embedded therein, wherein the additional DRAM die has through silicon via (TSV) interconnects formed through the additional DRAM die.

8. The semiconductor package assembly as claimed in claim 7, wherein the number of input/output (I/O) pins of the first semiconductor die is eight times greater than the number of input/output (I/O) pins of the second DRAM die.

9. The semiconductor package assembly as claimed in claim 7 or 8, wherein the first semiconductor package further comprises first vias disposed on the first semiconductor die, coupled to the first pads, and wherein the additional DRAM die is embedded in the first semiconductor package, coupled to the first vias on the first semiconductor die and the first RDL structure.

10. The semiconductor package assembly as claimed in claim 9, wherein the additional DRAM die is disposed between the first semiconductor die and the first RDL structure.

11. The semiconductor package assembly as claimed in claim 9 or 10, wherein the first semiconductor package further comprises:
a molding compound surrounding the first semiconductor die and the additional DRAM die, being in contact with the first RDL structure, the first semiconductor die and the additional DRAM die.

12. The semiconductor package assembly as claimed in claim 11, wherein the first semiconductor die is surrounded by second vias passing through the molding compound between the second semiconductor package and the first RDL structure.

13. The semiconductor package assembly as claimed in claim 11 or 12, wherein the additional DRAM die is surrounded by third vias passing through the molding compound between the first semiconductor die and the first RDL structure.

14. The semiconductor package assembly as claimed in any for the claims 6 to 13, wherein the second semiconductor package further comprises:
a second redistribution layer (RDL) structure disposed on the bump-attach surface.

15. The semiconductor package assembly as claimed in claim 14, wherein the additional DRAM die is disposed between the body and the second RDL structure.
